# EUROPEAN PATENT APPLICATION

(11) **EP 3 249 771 A1**
(43) Date of publication of application: **29.11.2017**
(21) Application number: 15877695.5
(22) Date of filing: 30.12.2015
(51) Int. Cl.: H02J 7/00

(54) **UNINTERRUPTED POWER SUPPLY AND CONTROL METHOD THEREOF**

(30) Priority: 13.01.2015 CN 201510017330
(71) Applicant: Eaton Manufacturing LP Glasgow, Succursale de Morges, 1110 Morges (CH)
(72) Inventor: CHEN, Qizhou, Shanghai 200335 (CN); CHEN, Tianyu, Shanghai 200335 (CN); XU, Jun, Shanghai 200335 (CN); GU, Jack, Shanghai 200335 (CN); ZHANG, Huali, Shenzhen Guangdong 518101 (CN)
(74) Representative: Wagner & Geyer
(86) International application number: PCT/CN2015/099829
(87) International publication number: WO 2016/112784

(57) **Abstract**

An uninterruptible power supply and a control method therefor. The uninterruptible power supply includes: an alternating current input end (20) and an alternating current output end (30); a rectification voltage regulating circuit (10), including a first diode (D1) and a first switching tube (Q1) that are connected in series, a second diode (D2) and a second switching tube (Q2) that are connected in series, and a third diode (D5) and a fourth diode (D6); an inverter voltage regulating circuit (40) including a third switching tube (Q3) and a fifth diode (D1') that are connected in series, a fourth switching tube (Q4) and a sixth diode (D2') that are connected in series, and a fifth switching tube (Q5) and a sixth switching tube (Q6); an inductor (L); a capacitor (C); a chargeable/dischargeable device for providing a direct current; a seventh switching tube (Q7) connected in series to an output end of the chargeable/dischargeable device; a safety diode (D7) connected in series to the seventh transistor (Q7); a charger (14); and a switch (S). The uninterruptible power supply can provide a stable alternating current, and does not have an automatic voltage regulator.

## Description

### TECHNICAL FIELD

The present invention relates to a power supply device, and in particular, to an uninterruptible power supply and a control method therefor.

### BACKGROUND

Uninterruptible power supplies can continuously supply power to electric equipment, and have been widely applied in various fields.

For an online interactive uninterruptible power supply, a load is powered directly by the mains supply when the mains supply is normal. The load is powered by batteries when the mains supply is interrupted. When the mains supply has a high or low voltage, to enable the online interactive uninterruptible power supply to have a stable output voltage, an automatic voltage regulator (AVR) is generally connected to an input end of the mains supply and used for regulating the voltage at an output end of the uninterruptible power supply. The automatic voltage regulator has high reliability and can regulate the voltage at the input end in a wide range.

However, the automatic voltage regulator has large volume, heavy weight, high costs, and high energy consumption, which directly cause decrease of power utilization rate and increase of costs of the uninterruptible power supply. Therefore, an uninterruptible power supply not having an automatic voltage regulator and capable of providing a stable alternating-current voltage is urgently needed at present.

### SUMMARY

In view of the aforementioned problem, an embodiment of the present invention provides an uninterruptible power supply, which includes:
an alternating current input end and an alternating current output end;
a rectification voltage regulating circuit, including a positive output end, a negative output end, and a first input end and a second input end that are electrically connected to the alternating current input end, and further including a first diode and a first switching tube that are connected in series between the first input end and the positive output end, a second diode and a second switching tube that are connected in series between the second input end and the positive output end, a third diode electrically connected between the negative output end and the first input end, and a fourth diode electrically connected between the negative output end and the second input end;
an inversion voltage regulating circuit, including a positive input end, a negative input end, a first output end, and a second output end, and further including a third switching tube and a fifth diode that are connected in series between the positive input end and the first output end, a fourth switching tube and a sixth diode that are connected in series between the positive input end and the second output end, a fifth switching tube electrically connected between the negative input end and the first output end, and a sixth switching tube electrically connected between the input end and the second output end;
an inductor electrically connected between the positive output end and the positive input end;
a capacitor electrically connected between the first output end and the second output end;
a chargeable/dischargeable device for providing a direct current;
a seventh switching tube, connected in series to an output end of the chargeable/dischargeable device between the negative output end and the positive output end;
a safety diode connected in series to the seventh switching tube, for preventing a current from flowing to the negative output end from the positive output end through the chargeable/dischargeable device;
a charger, for charging the chargeable/dischargeable device using an alternating current of the alternating current output end; and
a switch, for selectively electrically connecting the alternating current input end or one of the first output end and the second output end of the inversion voltage regulating circuit to the alternating current output end.

Preferably, the fifth switching tube and the sixth switching tube are thyristors.

Preferably, the chargeable/dischargeable device includes a rechargeable battery and a boost-type DC/DC converter, two ends of the rechargeable battery and an input end of the boost-type DC/DC converter are all electrically connected to an output end of the charger, and an output end of the boost-type DC/DC converter is the output end of the chargeable/dischargeable device.

An embodiment of the present invention provides a method for controlling an uninterruptible power supply. When a voltage of an alternating current of the alternating current input end is in a first predetermined range, the switch is controlled so that the first output end and the second output end of the inversion voltage regulating circuit are electrically connected to the alternating current output end, the seventh switching tube is controlled to be off, the first switching tube and the second switching tube are controlled to obtain a bucked pulsating direct-current voltage between the positive input end and the negative input end, and the inversion voltage regulating circuit is controlled to convert the pulsating direct-current voltage into a required alternating current.

Preferably, in a positive half cycle of the alternating current, the third switching tube and the sixth switching tube are controlled to be on, and complementary pulse-width modulation signals are provided to the first switching tube and the second switching tube; and in a negative half cycle of the alternating current, the fourth switching tube and the fifth switching tube are controlled to be on, and complementary pulse-width modulation signals are provided to the first switching tube and the second switching tube.

An embodiment of the present invention provides a method for controlling an uninterruptible power supply. When a voltage of an alternating current of the alternating current input end is in a second predetermined range, the switch is controlled so that the first output end and the second output end of the inversion voltage regulating circuit are electrically connected to the alternating current output end, the seventh switching tube is controlled to be off, the first switching tube and the second switching tube are controlled to obtain a pulsating direct-current voltage between the positive input end and the negative input end, and the inversion voltage regulating circuit is controlled to boost and convert the pulsating direct-current voltage into a required alternating current.

Preferably, in a positive half cycle of the alternating current, the first switching tube and the sixth switching tube are controlled to be on, and complementary pulse-width modulation signals are provided to the third switching tube and the fourth switching tube; and in a negative half cycle of the alternating current, the second switching tube and the fifth switching tube are controlled to be on, and complementary pulse-width modulation signals are provided to the third switching tube and the fourth switching tube.

An embodiment of the present invention provides a method for controlling an uninterruptible power supply. When a voltage of an alternating current of the alternating current input end is larger than a first threshold voltage or smaller than a second threshold voltage, the switch is controlled so that the first output end and the second output end of the inversion voltage regulating circuit are electrically connected to the alternating current output end, the first switching tube and/or the second switching tube is controlled so that a free-wheeling path is formed between the negative output end and the positive output end, the seventh switching tube is controlled to work so that a pulsating direct-current voltage is obtained between the positive input end and the negative input end, and the inversion voltage regulating circuit is controlled to convert the pulsating direct-current voltage into a required alternating current, where the first threshold voltage is larger than the second threshold voltage.

Preferably, when a direct-current voltage provided by the chargeable/dischargeable device is not smaller than a peak voltage of the alternating current required by the alternating current output end, the seventh switching tube is controlled to work in a pulse-width modulation mode, and the inversion voltage regulating circuit is controlled to alternately perform the following two steps:
1) in a positive half cycle of the required alternating current starting from a moment when the pulsating direct-current voltage is zero, controlling the third switching tube and the sixth switching tube to be on; and
2) in a negative half cycle of the required alternating current starting from a moment when the pulsating direct-current voltage is zero, controlling the fourth switching tube and the fifth switching tube to be on.

Preferably, when a direct-current voltage provided by the chargeable/dischargeable device is smaller than a peak voltage of the alternating current required by the alternating current output end, the control method includes periodically performing the following steps:
1) in a positive half cycle of the alternating current of the alternating current output end:
   11) in a period of time in which a voltage value of the alternating current output end rises from zero to the direct-current voltage provided by the chargeable/dischargeable device, controlling the seventh switching tube to work in a pulse-width modulation mode, and meanwhile controlling the third switching tube and the sixth switching tube to be on;
   12) in a period of time in which the voltage value of the alternating current output end is greater than the direct-current voltage provided by the chargeable/dischargeable device, controlling the seventh switching tube to be on, and meanwhile controlling the sixth switching tube to be on, and providing complementary pulse-width modulation signals to the third switching tube and the fourth switching tube; and
   13) in a period of time in which the voltage value of the alternating current output end drops from the direct-current voltage provided by the chargeable/dischargeable device to zero, controlling the seventh switching tube to work in a pulse-width modulation mode, and meanwhile controlling the third switching tube and the sixth switching tube to be on; and
2) in a negative half cycle of the alternating current of the alternating current output end:
   24) in a period of time in which the voltage value of the alternating current output end rises from zero to the direct-current voltage provided by the chargeable/dischargeable device, controlling the seventh switching tube to work in a pulse-width modulation mode, and meanwhile controlling the fourth switching tube and the fifth switching tube to be on;
   25) in a period of time in which the voltage value of the alternating current output end is greater than the direct-current voltage provided by the chargeable/dischargeable device, controlling the seventh switching tube to be on, controlling the fifth switching tube to be on, and providing complementary pulse-width modulation signals to the third switching tube and the fourth switching tube; and
   26) in a period of time in which the voltage value of the alternating current output end drops from the direct-current voltage provided by the chargeable/dischargeable device to zero, controlling the seventh switching tube to work in a pulse-width modulation mode, and meanwhile controlling the fourth switching tube and the fifth switching tube to be on.

Another embodiment of the present invention provides a method for controlling an uninterruptible power supply. When an alternating current of the alternating current input end is interrupted, the switch is controlled so that the first output end and the second output end of the inversion voltage regulating circuit are electrically connected to the alternating current output end, the first switching tube and/or the second switching tube is controlled so that a free-wheeling path is formed between the negative output end and the positive output end, and when a direct-current voltage provided by the rechargeable battery is smaller than a peak voltage of an alternating current required by the alternating current output end, the boost-type DC/DC converter and the seventh switching tube are controlled to work so that a pulsating direct-current voltage is obtained between the positive input end and the negative input end, and the inversion voltage regulating circuit is controlled to convert the pulsating direct-current voltage into the required alternating current.

Preferably, the boost-type DC/DC converter is controlled to work in a pulse-width modulation mode and output a direct current not smaller than the peak voltage of the required alternating current, the seventh switching tube is controlled to work in a pulse-width modulation mode, and meanwhile the following two steps are alternately performed:
1) in a first half cycle of the required alternating current starting from a moment when the pulsating direct-current voltage is zero, controlling the third switching tube and the sixth switching tube to be on; and
2) in a second half cycle of the required alternating current starting from a moment when the pulsating direct-current voltage is zero, controlling the fourth switching tube and the fifth switching tube to be on.

Preferably, the seventh switching tube is controlled to be on, the boost-type DC/DC converter is controlled to work in a pulse-width modulation mode and output a pulsating direct-current voltage, and meanwhile the following two steps are alternately performed:
1) in a first half cycle of the required alternating current starting from a moment when the pulsating direct-current voltage is zero, controlling the third switching tube and the sixth switching tube to be on; and
2) in a second half cycle of the required alternating current starting from a moment when the pulsating direct-current voltage is zero, controlling the fourth switching tube and the fifth switching tube to be on.

Another embodiment of the present invention provides a method for controlling an uninterruptible power supply. When an alternating current of the alternating current input end is in a predetermined range, the first switching tube, the second switching tube, the inversion voltage regulating circuit, and the seventh switching tube are controlled to stop working, and the switch is controlled so that the alternating current input end is electrically connected to the alternating current output end.

Another embodiment of the present invention provides a method for controlling an uninterruptible power supply. When an alternating current of the alternating current input end is in a predetermined range, the switch is controlled so that the first output end and the second output end of the inversion voltage regulating circuit are electrically connected to the alternating current output end, the first switching tube and the second switching tube are controlled to be on, the third switching tube and the sixth switching tube are controlled to be on in a positive half cycle of the alternating current, and the fourth switching tube and the fifth switching tube are controlled to be on in a negative half cycle of the alternating current.

The uninterruptible power supply of the present invention can provide a stable alternating current, does not have an automatic voltage regulator, uses few components and has low costs, and meanwhile has improved power utilization efficiency.

### BRIEF DESCRIPTION OF THE DRAWINGS

The embodiments of the present invention are further described below with reference to the accompanying drawings, in which:
FIG. 1 is a circuit diagram of an uninterruptible power supply according to a first embodiment of the present invention;
FIG. 2 is an equivalent circuit diagram of the uninterruptible power supply shown in FIG. 1 in an online mode;
FIG. 3 is a sequence diagram of pulse-width modulation signals realizing voltage bucking in the online mode;
FIG. 4 is a sequence diagram of pulse-width modulation signals realizing voltage boosting in the online mode;
FIG. 5 is an equivalent circuit diagram of the uninterruptible power supply shown in FIG. 1 in a backup mode;
FIG. 6 is an equivalent circuit diagram of the uninterruptible power supply shown in FIG. 1 in a first bypass mode;
FIG. 7 is an equivalent circuit diagram of the uninterruptible power supply shown in FIG. 1 in a second bypass mode;
FIG. 8 is a circuit diagram of an uninterruptible power supply according to a second embodiment of the present invention; and
FIG. 9 is an equivalent circuit diagram of the uninterruptible power supply shown in FIG. 8 in a backup mode.

### DETAILED DESCRIPTION OF THE EMBODIMENTS

In order to make the objectives, technical solutions and advantages of the present invention more clear, the present invention is further described in detail below through specific embodiments with reference to the accompanying drawings.

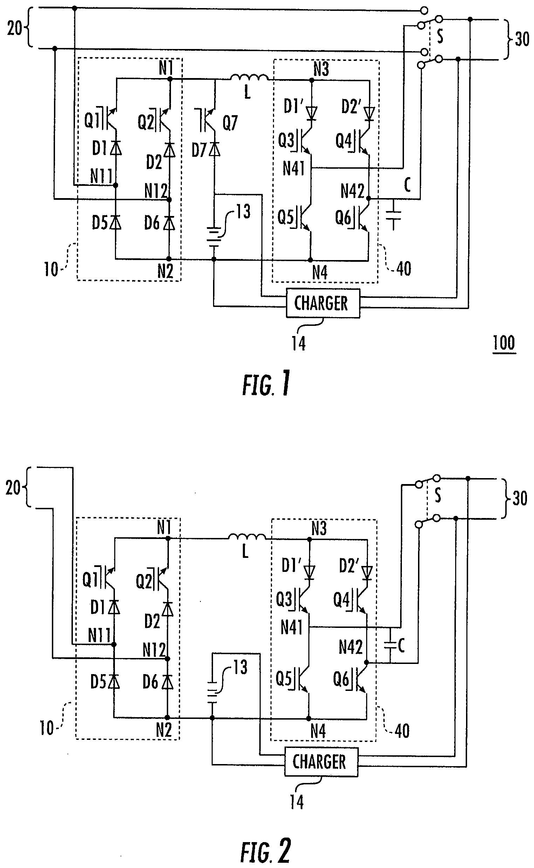

FIG. 1 is a circuit diagram of an uninterruptible power supply according to a first embodiment of the present invention. As shown in FIG. 1, the uninterruptible power supply 100 includes an alternating current input end 20, a switch S, an alternating current output end 30, a rectification voltage regulating circuit 10, an inversion voltage regulating circuit 40, an insulated gate bipolar transistor Q7, a diode D7, an inductor L, a capacitor C, a rechargeable battery 13, and a charger 14.

The rectification voltage regulating circuit 10 includes diodes D1, D2, D5, and D6, insulated gate bipolar transistors Q1 and Q2, input ends N11 and N12 electrically connected to the alternating current input end 20, and a positive output end N1 and a negative output end N2 used for providing direct current output. The diode D1 and the insulated gate bipolar transistor Q1 are connected in series between the input end N11 and the positive output end N1, that is, a collector of the insulated gate bipolar transistor Q1 is connected to a cathode of the diode D1, or an emitter of the insulated gate bipolar transistor Q1 is connected to an anode of the diode D1. The diode D2 and the insulated gate bipolar transistor Q2 are connected in series between the input end N12 and the positive output end N1, that is, a collector of the insulated gate bipolar transistor Q2 is connected to a cathode of the diode D2, or an emitter of the insulated gate bipolar transistor Q2 is connected to an anode of the diode D2. An anode of the diode D5 is electrically connected to the negative output end N2, and a cathode of the diode D5 is connected to the input end N11. An anode of the diode D6 is electrically connected to the negative output end N2, and a cathode of the diode D6 is connected to the input end N12.

The inversion voltage regulating circuit 40 includes insulated gate bipolar transistors Q3, Q4, Q5, and Q6, and diodes D1' and D2', and further includes a positive input end N3, a negative input end N4, and an output end N41 and an output end N42 used for providing alternating current output. The insulated gate bipolar transistor Q3 and the diode D1' are connected in series between the positive input end N3 and the output end N41, that is, a cathode of the diode D1' is connected to a collector of the insulated gate bipolar transistor Q3, or an anode of the diode D1' is connected to an emitter of the insulated gate bipolar transistor Q3. The insulated gate bipolar transistor Q4 and the diode D2' are connected in series between the positive input end N3 and the output end N42, that is, a cathode of the diode D2' is connected to a collector of the insulated gate bipolar transistor Q4, or an anode of the diode D2' is connected to an emitter of the insulated gate bipolar transistor Q4. Emitters of the insulated gate bipolar transistors Q5 and Q6 are connected to the negative input end N4, and collectors of the insulated gate bipolar transistors Q5 and Q6 are respectively connected to the output end N41 and the output end N42. That is, the insulated gate bipolar transistor Q5 is electrically connected between the negative input end N4 and the output end N41, and the insulated gate bipolar transistor Q6 is electrically connected between the negative input end N4 and the output end N42.

The capacitor C is connected to output ends (namely, the output ends N41 and N42) of the inversion voltage regulating circuit 40. The inductor L is connected between the positive output end N1 and the positive input end N3 (that is, electrically connected to the positive output end N1 and the positive input end N3). The negative output end N2 is electrically connected to the negative input end N4.

The rechargeable battery 13, the diode D7, and the insulated gate bipolar transistor Q7 are sequentially connected in series, and a cathode of the rechargeable battery 13 is electrically connected to the negative output end N2, an anode of the rechargeable battery 13 is connected to an anode of the diode D7, a cathode of the diode D7 is connected to a collector of the insulated gate bipolar transistor Q7, and an emitter of the insulated gate bipolar transistor Q7 is electrically connected to the positive output end N1. An input end of the charger 14 is electrically connected to the alternating current output end 30, and an output end of the charger 14 is electrically connected to two ends of the rechargeable battery 13 for charging the rechargeable battery 13. The switch S selectively electrically connects the alternating current input end 20 or the output ends of the inversion voltage regulating circuit 40 to the alternating current output end 30.

FIG. 2 is an equivalent circuit diagram of the uninterruptible power supply shown in FIG. 1 in an online mode. When a voltage of an alternating current provided by the alternating current input end 20 is in a first predetermined range or a second predetermined range, the switch S is controlled so that the output ends of the inversion voltage regulating circuit 40 are electrically connected to the alternating current output end 30 and the insulated gate bipolar transistor Q7 (not shown in FIG. 2) turns off. At this time, the uninterruptible power supply 100 is in an online mode. A voltage in the first predetermined range is slightly higher than a voltage required by the alternating current output end 30, and a voltage in the second predetermined range is slightly lower than the voltage required by the alternating current output end 30. The first predetermined range and the second predetermined range may be selected according to the actual application, and the specific ranges are not limited herein.

Voltage bucking may be realized in the following manner based on the equivalent circuit shown in FIG. 2 and the basic principle of a buck conversion circuit (for example, a Buck circuit). For example, in a positive half cycle of an alternating current, a pulse-width modulation signal is provided to the insulated gate bipolar transistor Q1 so that the insulated gate bipolar transistor Q1 is equivalent to a switching tube in the Buck circuit, and the insulated gate bipolar transistor Q2 is controlled to be on so that it forms, together with the diodes D6 and D2, part of a free-wheeling path (that is, equivalent to a diode in the Buck circuit), and the insulated gate bipolar transistors Q3 and Q6 are controlled to be on to realize a bucked-voltage output.

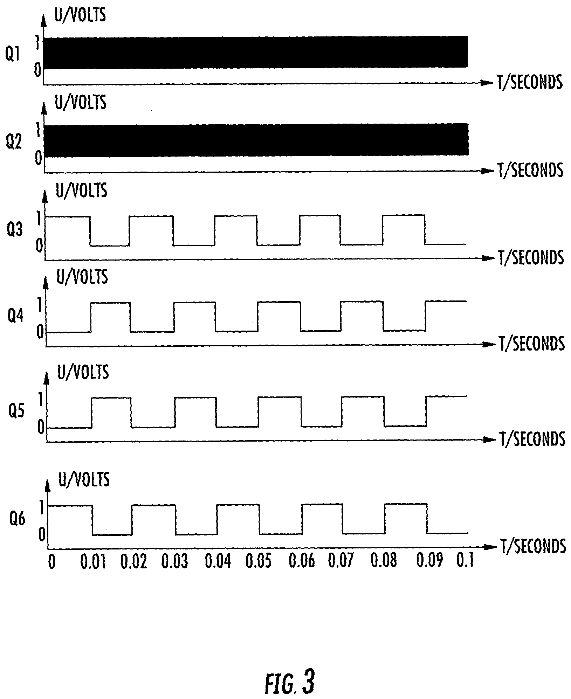

FIG. 3 is a sequence diagram of pulse-width modulation signals realizing voltage bucking in the online mode. Pulse-width modulation signals (denoted by black filled lines in FIG. 3) of the insulated gate bipolar transistors Q1 and Q2 are complementary, and the frequencies thereof are not limited herein. The working state of the uninterruptible power supply in one cycle of an alternating current having a frequency of 50 Hz will be described in detail below with reference to FIG. 3. In a positive half cycle of the alternating current, the following two control processes are alternately performed: 1) controlling the insulated gate bipolar transistors Q1, Q3, and Q6 to be on; and 2) controlling the insulated gate bipolar transistors Q2, Q3, and Q6 to be on. In a negative half cycle of the alternating current, the following two control processes are alternately performed: 1) controlling the insulated gate bipolar transistors Q2, Q4, and Q5 to be on; and 2) controlling the insulated gate bipolar transistors Q1, Q4, and Q5 to be on. A bucked pulsating direct-current voltage can be obtained between the positive input end N3 and the negative input end N4 through the aforementioned control process, and the cycle of the pulsating direct-current voltage is half (0.01 second) of the cycle of the alternating current, and a required sine-wave voltage is obtained at the alternating current output end 30.

Voltage boosting may be realized in the following manner based on the equivalent circuit shown in FIG. 2 and the basic principle of a boost conversion circuit (for example, a Boost circuit). For example, in a positive half cycle of an alternating current, the insulated gate bipolar transistors Q1 and Q6 are controlled to be on to form part of a free-wheeling path, and complementary pulse-width modulation signals are provided to the insulated gate bipolar transistors Q3 and Q4 so that the insulated gate bipolar transistor Q4 is equivalent to a switching tube in the Boost circuit. When the insulated gate bipolar transistor Q4 turns on, the inductor L charges; when the insulated gate bipolar transistor Q3 turns on, the inductor L discharges, thereby realizing voltage boosting. In a negative half cycle of the alternating current, the insulated gate bipolar transistors Q2 and Q5 are controlled to be on to form part of a free-wheeling path, and complementary pulse-width modulation signals are provided to the insulated gate bipolar transistors Q3 and Q4 so that the insulated gate bipolar transistor Q3 is equivalent to a switching tube in the Boost circuit. When the insulated gate bipolar transistor Q3 turns on, the inductor L charges; when the insulated gate bipolar transistor Q4 turns on, the inductor L discharges, thereby realizing voltage boosting.

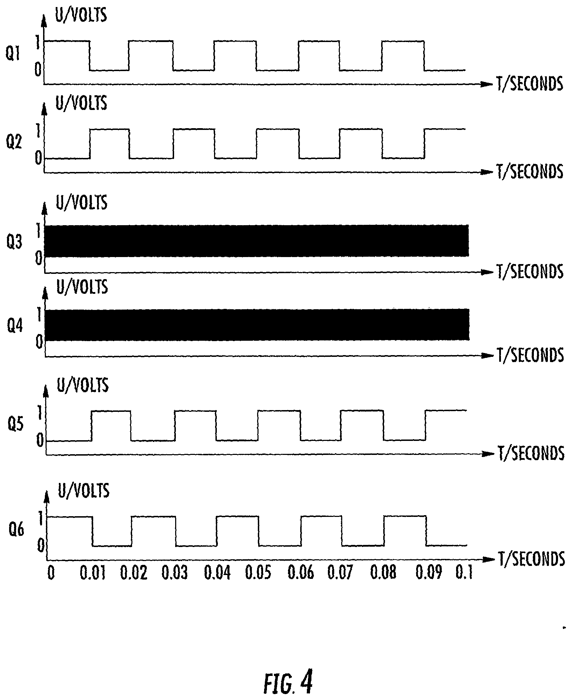

FIG. 4 is a sequence diagram of pulse-width modulation signals realizing voltage boosting in the online mode. Pulse-width modulation signals (denoted by black filled lines in FIG. 4) of the insulated gate bipolar transistors Q3 and Q4 are complementary, and the frequencies thereof are not limited herein. The working state of the uninterruptible power supply in one cycle of an alternating current having a frequency of 50 Hz will be described in detail below with reference to FIG. 4. In a positive half cycle of the alternating current, the following two control processes are alternately performed: 1) controlling the insulated gate bipolar transistors Q1, Q4, and Q6 to be on; and 2) controlling the insulated gate bipolar transistors Q1, Q3, and Q6 to be on. In a negative half cycle of the alternating current, the following two control processes are alternately performed: 1) controlling the insulated gate bipolar transistors Q2, Q3, and Q5 to be on; and 2) controlling the insulated gate bipolar transistors Q2, Q4, and Q5 to be on. A rectified pulsating direct-current voltage can be obtained between the positive input end N3 and the negative input end N4 through the aforementioned control process, and a boosted sine-wave voltage is obtained at the alternating current output end 30.

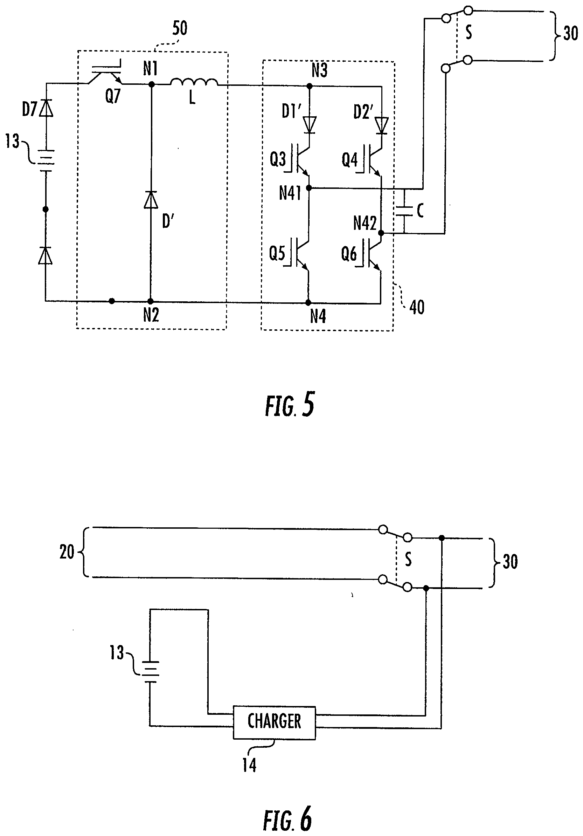

FIG. 5 is an equivalent circuit diagram of the uninterruptible power supply shown in FIG. 1 in a backup mode. When a voltage of an alternating current is less than a lower limit value (namely, a second threshold voltage) of the second predetermined range or greater than an upper limit value (namely, a first threshold voltage) of the first predetermined range, the switch S is controlled so that the output ends of the inversion voltage regulating circuit 40 are electrically connected to the alternating current output end 30, and the insulated gate bipolar transistor Q1 and/or the insulated gate bipolar transistor Q2 is controlled to be on or alternately on. As shown in FIG. 5, a free-wheeling diode D' between the positive output end N1 and the negative output end N2 is an equivalent diode between the positive output end N1 and the negative output end N2 when the insulated gate bipolar transistor Q1 and/or the insulated gate bipolar transistor Q2 turns on. It can be seen from FIG. 5 that the free-wheeling diode D', the insulated gate bipolar transistor Q7, and the inductor L constitute a Buck circuit 50. The insulated gate bipolar transistor Q7 is controlled to work in a pulse-width modulation mode, so that a pulsating direct-current voltage is obtained between the positive input end N3 and the negative input end N4 and has a cycle being half of the cycle of an alternating current required by the alternating current output end 30.

Control is performed in the following two situations depending on the direct-current voltage of the rechargeable battery 13. In the first situation, if the direct current of the rechargeable battery 13 is not smaller than a peak voltage of the alternating current required by the alternating current output end 30, the insulated gate bipolar transistor Q7 is controlled to work in a pulse-width modulation mode, so that a peak value of the pulsating direct-current voltage obtained between the positive input end N3 and the negative input end N4 is equal to or approximately equal to a peak value of the voltage required by the alternating current output end 30. Gate driving signals respectively provided to the insulated gate bipolar transistors Q3, Q4, Q5, and Q6 are the same as gate driving signals of the insulated gate bipolar transistors Q3, Q4, Q5, and Q6 in FIG. 3, so as to invert the pulsating direct-current voltage into a sine-wave voltage and output the sine-wave voltage. That is, the following two processes are alternately performed: 1) in a positive half cycle of the required alternating current starting from a moment when the pulsating direct-current voltage is zero, controlling the insulated gate bipolar transistors Q3 and Q6 to be on; and 2) in a negative half cycle of the required alternating current starting from a moment when the pulsating direct-current voltage is zero, controlling the insulated gate bipolar transistors Q4 and Q5 to be on.

In the second situation, if the direct-current voltage of the rechargeable battery 13 is smaller than the peak voltage of the required alternating current, the insulated gate bipolar transistor Q7 is controlled to work, so that a pulsating direct-current voltage is obtained between the positive input end N3 and the negative input end N4, and the inversion voltage regulating circuit 40 is controlled to work so as to obtain the alternating current having the required amplitude at the alternating current output end 30. In one cycle of the alternating current of the alternating current output end 30, the specific control process is as follows: in a positive half cycle of alternating current output, 11) in a period of time in which a voltage value of the alternating current output end 30 rises from zero to a direct-current voltage value of the rechargeable battery 13, controlling the insulated gate bipolar transistor Q7 to work in a pulse-width modulation mode so that it is equivalent to a switching tube in the Buck circuit, and meanwhile controlling the insulated gate bipolar transistors Q3 and Q6 to be on; 12) in a period of time in which the voltage value of the alternating current output end 30 is greater than the direct-current voltage value of the rechargeable battery 13, controlling the insulated gate bipolar transistor Q7 to be on, and meanwhile controlling the insulated gate bipolar transistor Q6 to be on, and providing complementary pulse-width modulation signals to the insulated gate bipolar transistors Q3 and Q4, so that the insulated gate bipolar transistor Q4 is equivalent to a switching tube in the Boost circuit; and 13) in a period of time in which the voltage value of the alternating current output end 30 drops from the direct-current voltage value of the rechargeable battery 13 to zero, controlling the insulated gate bipolar transistor Q7 to work in a pulse-width modulation mode so that it is equivalent to a switching tube in the Buck circuit, and meanwhile controlling the insulated gate bipolar transistors Q3 and Q6 to be on; and in a negative half cycle of the alternating current output, 21) in a period of time in which the voltage value of the alternating current output end 30 rises from zero to the direct-current voltage value of the rechargeable battery 13, controlling the insulated gate bipolar transistor Q7 to work in a pulse-width modulation mode so that it is equivalent to a switching tube in the Buck circuit, and meanwhile controlling the insulated gate bipolar transistors Q4 and Q5 to be on; 22) in a period of time in which the voltage value of the alternating current output end 30 is greater than the direct-current voltage value of the rechargeable battery 13, controlling the insulated gate bipolar transistor Q7 to be on, controlling the insulated gate bipolar transistor Q5 to be on, and providing complementary pulse-width modulation signals to the insulated gate bipolar transistor Q3 and the insulated gate bipolar transistor Q4, so that the insulated gate bipolar transistor Q4 is equivalent to a switching tube in the Boost circuit; and 23) in a period of time in which the voltage value of the alternating current output end 30 drops from the direct-current voltage value of the rechargeable battery 13 to zero, controlling the insulated gate bipolar transistor Q7 to work in a pulse-width modulation mode so that it is equivalent to a switching tube in the Buck circuit, and meanwhile controlling the insulated gate bipolar transistors Q4 and Q5 to be on.

FIG. 6 is an equivalent circuit diagram of the uninterruptible power supply shown in FIG. 1 in a first bypass mode. When an alternating current provided by the alternating current input end 20 satisfies a voltage range required by the alternating current output end 30, the insulated gate bipolar transistors Q1-Q7 (not shown in FIG. 6) are made off, and the switch S is controlled to electrically connect the alternating current input end 20 to the alternating current output end 30. The alternating current input end 20 supplies power to the alternating current output end 30, and meanwhile the charger 14 selects to charge or not charge the rechargeable battery 13 depending on the electric quantity of the rechargeable battery 13.

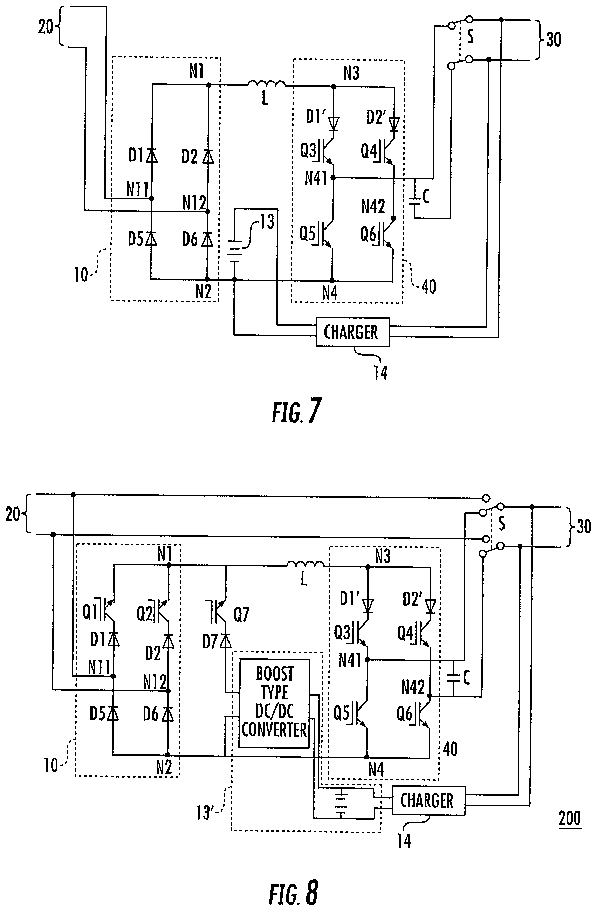

FIG. 7 is an equivalent circuit diagram of the uninterruptible power supply shown in FIG. 1 in a second bypass mode. The switch S is controlled so that the alternating current output end 30 is connected to output ends of the inversion voltage regulating circuit 40, the insulated gate bipolar transistors Q1 and Q2 are controlled to be on (the insulated gate bipolar transistors Q1 and Q2 are equivalent to wires in FIG. 7), and the pulse-width modulation signals of the insulated gate bipolar transistors Q3, Q4, Q5, and Q6 in FIG. 3 are respectively provided to the insulated gate bipolar transistors Q3, Q4, Q5, and Q6, that is, the inversion voltage regulating circuit 40 is controlled to invert a pulsating direct-current voltage between the positive input end N3 and the negative input end N4 into a sinusoidal alternating-current voltage. Meanwhile, the charger 14 selects to charge or not charge the rechargeable battery 13 depending on the electric quantity of the rechargeable battery 13.

FIG. 8 is a circuit diagram of an uninterruptible power supply according to a second embodiment of the present invention. FIG. 8 is substantially the same as FIG. 1, and the difference lies in that: the uninterruptible power supply 200 further includes a boost-type DC/DC converter 15, the boost-type DC/DC converter 15 has input ends connected to two ends of the rechargeable battery 13 and constitutes, together with the rechargeable battery 13, a chargeable/dischargeable device 13' for providing a direct current. The chargeable/dischargeable device 13', the diode D7, and the insulated gate bipolar transistor Q7 are connected in series, and one output terminal of the chargeable/dischargeable device 13' (namely, one output terminal of the boost-type DC/DC converter 15) is connected to the negative output end N2. The online mode and bypass mode of the uninterruptible power supply 200 are the same as those of the uninterruptible power supply 100 in FIG. 1, and will not be described herein again.

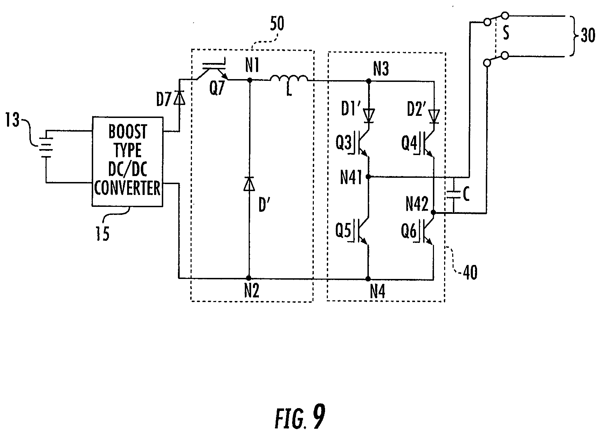

The uninterruptible power supply 200 is mainly used in the situation that the voltage of the rechargeable battery 13 is smaller than the peak voltage required by the alternating current output end 30. In a backup mode, the switch S is controlled so that the output ends of the inversion voltage regulating circuit 40 are electrically connected to the alternating current output end 30, and the insulated gate bipolar transistor Q1 and/or the insulated gate bipolar transistor Q2 is controlled so that a free-wheeling path is formed between the negative output end N2 and the positive output end N1. An equivalent circuit diagram of the uninterruptible power supply 200 in the backup mode is shown in FIG. 9, where the free-wheeling diode D', the insulated gate bipolar transistor Q7, and the inductor L constitute a Buck circuit 50. The boost-type DC/DC converter 15 and the insulated gate bipolar transistor Q7 are controlled so that the cycle of a pulsating direct-current voltage obtained between the positive input end N3 and the negative input end N4 is half of the cycle of an alternating current required by the alternating current output end 30, and a peak value of the pulsating direct-current voltage is equal to or substantially equal to a peak voltage of the required alternating current, and the inversion voltage regulating circuit 40 is controlled to invert the pulsating direct-current voltage into an alternating current and output the alternating current to the alternating current output end 30. The uninterruptible power supply 200 may specifically work in the following two manners:
(1) The boost-type DC/DC converter 15 is controlled to work in a pulse-width modulation mode and output a direct current (having a substantially unchanged amplitude) not smaller than the peak voltage required by the alternating current output end 30, the insulated gate bipolar transistor Q7 is controlled to work in a pulse-width modulation mode, so as to obtain a pulsating direct-current voltage between the positive input end N3 and the negative input end N4, and the inversion voltage regulating circuit 40 is controlled to convert the pulsating direct-current voltage between the positive input end N3 and the negative input end N4 into an alternating current and output the alternating current to the alternating current output end 30.
(2) The insulated gate bipolar transistor Q7 is controlled to be on all the time, the boost-type DC/DC converter 15 is controlled to work in a pulse-width modulation mode and obtain a pulsating direct-current voltage between the positive input end N3 and the negative input end N4, and the inversion voltage regulating circuit 40 is controlled to convert the pulsating direct-current voltage between the positive input end N3 and the negative input end N4 into an alternating current and output the alternating current to the alternating current output end 30. The boost-type DC/DC converter 15 in this embodiment may be any boost-type, for example, isolated or non-isolated, DC/DC conversion circuit.

The advantage of the uninterruptible power supply 200 having the boost-type DC/DC converter 15 is: once the alternating current of the alternating current input end 20 is normal, since the pulse-width modulation signals of the insulated gate bipolar transistors Q3, Q4, Q5, and Q6 in a battery power supply mode are the same as the pulse-width modulation signals in the bypass mode, the uninterruptible power supply 200 can conveniently and rapidly switch to the bypass mode.

The diode D7 in the aforementioned embodiments can prevent the current from flowing to the negative output end N2 from the positive output end N1 through the rechargeable battery 13. In other embodiments of the present invention, when the voltage between the positive output end N1 and the negative output end N2 is smaller than the voltage of the rechargeable battery 13, the insulated gate bipolar transistor Q7 may not be connected in series to the diode D7 (that is, not have the diode D7.)

In other embodiments of the present invention, metal-oxide-semiconductor field effect transistors may be used to replace the insulated gate bipolar transistors Q1, Q2, Q3, Q4, Q5, Q6, and Q7. In other embodiments of the present invention, thyristors may be used to replace the insulated gate bipolar transistors Q5 and Q6. The insulated gate bipolar transistors Q1, Q2, Q7, Q3, and Q4 in the uninterruptible power supply of the present invention may be any fully-controlled switching devices.

A person skilled in the art knows that an equivalent circuit of a reverse blocking insulated gate bipolar transistor (RBIGBT) is a circuit formed by an insulated gate bipolar transistor and a diode connected in series, and therefore, in other embodiments of the present invention, a reverse blocking insulated gate bipolar transistor may be used to replace the diode D1 and the insulated gate bipolar transistor Q1 that are connected in series, the diode D2 and the insulated gate bipolar transistor Q2 that are connected in series, the diode D1' and the insulated gate bipolar transistor Q3 that are connected in series, the diode D2' and the insulated gate bipolar transistor Q4 that are connected in series, or the diode D7 and the insulated gate bipolar transistor Q7 that are connected in series in the aforementioned embodiments.

The uninterruptible power supply of the present invention can provide a stable alternating current, does not have an automatic voltage regulator, uses few components and has low costs, and meanwhile has improved power utilization efficiency.

Although the present invention has been described through preferred embodiments, the present invention is not limited to the embodiments described herein and further includes various changes and variations made without departing from the scope of the present invention.

## Claims

1. An uninterruptible power supply, comprising:
an alternating current input end (20) and an alternating current output end (30);
a rectification voltage regulating circuit (10), comprising a positive output end (N1), a negative output end (N2), and a first input end (N11) and a second input end (N12) that are electrically connected to the alternating current input end (20), and further comprising a first diode (D1) and a first switching tube (Q1) that are connected in series between the first input end (N11) and the positive output end (N1), a second diode (D2) and a second switching tube (Q2) that are connected in series between the second input end (N12) and the positive output end (N1), a third diode (D5) electrically connected between the negative output end (N2) and the first input end (N11), and a fourth diode (D6) electrically connected between the negative output end (N2) and the second input end (N12);
an inversion voltage regulating circuit (40), comprising a positive input end (N3), a negative input end (N4), a first output end (N41), and a second output end (N42), and further comprising a third switching tube (Q3) and a fifth diode (D1') that are connected in series between the positive input end (N3) and the first output end (N41), a fourth switching tube (Q4) and a sixth diode (D2') that are connected in series between the positive input end (N3) and the second output end (N42), a fifth switching tube (Q5) electrically connected between the negative input end (N4) and the first output end (N41), and a sixth switching tube (Q6) electrically connected between the input end (N4) and the second output end (N42);
an inductor (L) electrically connected between the positive output end (N1) and the positive input end (N3);
a capacitor (C) electrically connected between the first output end (N41) and the second output end (N42);
a chargeable/dischargeable device for providing a direct current;
a seventh switching tube (Q7), connected in series to an output end of the chargeable/dischargeable device between the negative output end (N2) and the positive output end (N1);
a safety diode (D7) connected in series to the seventh switching tube (Q7), for preventing a current from flowing to the negative output end (N2) from the positive output end (N1) through the chargeable/dischargeable device;
a charger (14), for charging the chargeable/dischargeable device using an alternating current of the alternating current output end (30); and
a switch (S), for selectively electrically connecting the alternating current input end (20) or one of the first output end and the second output end of the inversion voltage regulating circuit (40) to the alternating current output end (30).

2. The uninterruptible power supply according to claim 1, wherein the fifth switching tube (Q5) and the sixth switching tube (Q6) are thyristors.

3. The uninterruptible power supply according to claim 1 or 2, wherein the chargeable/dischargeable device comprises a rechargeable battery and a boost-type DC/DC converter (15), two ends of the rechargeable battery and an input end of the boost-type DC/DC converter (15) are all electrically connected to an output end of the charger (14), and an output end of the boost-type DC/DC converter (15) is the output end of the chargeable/dischargeable device.

4. A method for controlling the uninterruptible power supply according to any one of claims 1 to 3, wherein when a voltage of an alternating current of the alternating current input end (20) is in a first predetermined range, the switch (S) is controlled so that the first output end (N41) and the second output end (N42) of the inversion voltage regulating circuit (40) are electrically connected to the alternating current output end (30), the seventh switching tube (Q7) is controlled to be off, the first switching tube (Q1) and the second switching tube (Q2) are controlled to obtain a bucked pulsating direct-current voltage between the positive input end (N3) and the negative input end (N4), and the inversion voltage regulating circuit (40) is controlled to convert the pulsating direct-current voltage into a required alternating current.

5. The method for controlling the uninterruptible power supply according to claim 4, wherein
in a positive half cycle of the alternating current, the third switching tube (Q3) and the sixth switching tube (Q6) are controlled to be on, and complementary pulse-width modulation signals are provided to the first switching tube (Q1) and the second switching tube (Q2); and
in a negative half cycle of the alternating current, the fourth switching tube (Q4) and the fifth switching tube (Q5) are controlled to be on, and complementary pulse-width modulation signals are provided to the first switching tube (Q1) and the second switching tube (Q2).

6. A method for controlling the uninterruptible power supply according to any one of claims 1 to 3, wherein when a voltage of an alternating current of the alternating current input end (20) is in a second predetermined range, the switch (S) is controlled so that the first output end (N41) and the second output end (N42) of the inversion voltage regulating circuit (40) are electrically connected to the alternating current output end (30), the seventh switching tube (Q7) is controlled to be off, the first switching tube (Q1) and the second switching tube (Q2) are controlled to obtain a pulsating direct-current voltage between the positive input end (N3) and the negative input end (N4), and the inversion voltage regulating circuit (40) is controlled to boost and convert the pulsating direct-current voltage into a required alternating current.

7. The method for controlling the uninterruptible power supply according to claim 6, wherein
in a positive half cycle of the alternating current, the first switching tube (Q1) and the sixth switching tube (Q6) are controlled to be on, and complementary pulse-width modulation signals are provided to the third switching tube (Q3) and the fourth switching tube (Q4); and
in a negative half cycle of the alternating current, the second switching tube (Q2) and the fifth switching tube (Q5) are controlled to be on, and complementary pulse-width modulation signals are provided to the third switching tube (Q3) and the fourth switching tube (Q4).

8. A method for controlling the uninterruptible power supply according to claim 1 or 2, wherein when a voltage of an alternating current of the alternating current input end (20) is larger than a first threshold voltage or smaller than a second threshold voltage, the switch (S) is controlled so that the first output end (N41) and the second output end (N42) of the inversion voltage regulating circuit (40) are electrically connected to the alternating current output end (30), the first switching tube (Q1) and/or the second switching tube (Q2) is controlled so that a free-wheeling path is formed between the negative output end (N2) and the positive output end (N1), the seventh switching tube (Q7) is controlled to work so that a pulsating direct-current voltage is obtained between the positive input end (N3) and the negative input end (N4), and the inversion voltage regulating circuit (40) is controlled to convert the pulsating direct-current voltage into a required alternating current, wherein the first threshold voltage is larger than the second threshold voltage.

9. The method for controlling the uninterruptible power supply according to claim 8, wherein when a direct-current voltage provided by the chargeable/dischargeable device is not smaller than a peak voltage of the alternating current required by the alternating current output end (30), the seventh switching tube (Q7) is controlled to work in a pulse-width modulation mode, and the inversion voltage regulating circuit (40) is controlled to alternately perform the following two steps:
1) in a positive half cycle of the required alternating current starting from a moment when the pulsating direct-current voltage is zero, controlling the third switching tube (Q3) and the sixth switching tube (Q6) to be on; and
2) in a negative half cycle of the required alternating current starting from a moment when the pulsating direct-current voltage is zero, controlling the fourth switching tube (Q4) and the fifth switching tube (Q5) to be on.

10. The method for controlling the uninterruptible power supply according to claim 8, wherein when a direct-current voltage provided by the chargeable/dischargeable device is smaller than a peak voltage of the alternating current required by the alternating current output end (30), the control method comprises periodically performing the following steps:
1) in a positive half cycle of the alternating current of the alternating current output end (30):
11) in a period of time in which a voltage value of the alternating current output end (30) rises from zero to the direct-current voltage provided by the chargeable/dischargeable device, controlling the seventh switching tube (Q7) to work in a pulse-width modulation mode, and meanwhile controlling the third switching tube (Q3) and the sixth switching tube (Q6) to be on;
12) in a period of time in which the voltage value of the alternating current output end (30) is greater than the direct-current voltage provided by the chargeable/dischargeable device, controlling the seventh switching tube (Q7) to be on, and meanwhile controlling the sixth switching tube (Q6) to be on, and providing complementary pulse-width modulation signals to the third switching tube (Q3) and the fourth switching tube (Q4); and
13) in a period of time in which the voltage value of the alternating current output end (30) drops from the direct-current voltage provided by the chargeable/dischargeable device to zero, controlling the seventh switching tube (Q7) to work in a pulse-width modulation mode, and meanwhile controlling the third switching tube (Q3) and the sixth switching tube (Q6) to be on; and
2) in a negative half cycle of the alternating current of the alternating current output end (30):
24) in a period of time in which the voltage value of the alternating current output end (30) rises from zero to the direct-current voltage provided by the chargeable/dischargeable device, controlling the seventh switching tube (Q7) to work in a pulse-width modulation mode, and meanwhile controlling the fourth switching tube (Q4) and the fifth switching tube (Q5) to be on;
25) in a period of time in which the voltage value of the alternating current output end (30) is greater than the direct-current voltage provided by the chargeable/dischargeable device, controlling the seventh switching tube (Q7) to be on, controlling the fifth switching tube (Q5) to be on, and providing complementary pulse-width modulation signals to the third switching tube (Q3) and the fourth switching tube (Q4); and
26) in a period of time in which the voltage value of the alternating current output end (30) drops from the direct-current voltage provided by the chargeable/dischargeable device to zero, controlling the seventh switching tube (Q7) to work in a pulse-width modulation mode, and meanwhile controlling the fourth switching tube (Q4) and the fifth switching tube (Q5) to be on.

11. A method for controlling the uninterruptible power supply according to claim 3, wherein when an alternating current of the alternating current input end (20) is interrupted, the switch (S) is controlled so that the first output end (N41) and the second output end (N42) of the inversion voltage regulating circuit (40) are electrically connected to the alternating current output end (30), the first switching tube (Q1) and/or the second switching tube (Q2) is controlled so that a free-wheeling path is formed between the negative output end (N2) and the positive output end (N1), and when a direct-current voltage provided by the rechargeable battery is smaller than a peak voltage of an alternating current required by the alternating current output end (30), the boost-type DC/DC converter (15) and the seventh switching tube (Q7) are controlled to work so that a pulsating direct-current voltage is obtained between the positive input end (N3) and the negative input end (N4), and the inversion voltage regulating circuit (40) is controlled to convert the pulsating direct-current voltage into the required alternating current.

12. The method for controlling the uninterruptible power supply according to claim 11, wherein the boost-type DC/DC converter (15) is controlled to work in a pulse-width modulation mode and output a direct current not smaller than the peak voltage of the required alternating current, the seventh switching tube (Q7) is controlled to work in a pulse-width modulation mode, and meanwhile the following two steps are alternately performed:
1) in a first half cycle of the required alternating current starting from a moment when the pulsating direct-current voltage is zero, controlling the third switching tube (Q3) and the sixth switching tube (Q6) to be on; and
2) in a second half cycle of the required alternating current starting from a moment when the pulsating direct-current voltage is zero, controlling the fourth switching tube (Q4) and the fifth switching tube (Q5) to be on.

13. The method for controlling the uninterruptible power supply according to claim 11, wherein the seventh switching tube (Q7) is controlled to be on, the boost-type DC/DC converter (15) is controlled to work in a pulse-width modulation mode and output a pulsating direct-current voltage, and meanwhile the following two steps are alternately performed:
1) in a first half cycle of the required alternating current starting from a moment when the pulsating direct-current voltage is zero, controlling the third switching tube (Q3) and the sixth switching tube (Q6) to be on; and
2) in a second half cycle of the required alternating current starting from a moment when the pulsating direct-current voltage is zero, controlling the fourth switching tube (Q4) and the fifth switching tube (Q5) to be on.

14. A method for controlling the uninterruptible power supply according to any one of claims 1 to 3, wherein when an alternating current of the alternating current input end (20) is in a predetermined range, the first switching tube (Q1), the second switching tube (Q2), the inversion voltage regulating circuit (40), and the seventh switching tube (Q7) are controlled to stop working, and the switch (S) is controlled so that the alternating current input end (20) is electrically connected to the alternating current output end (30).

15. A method for controlling the uninterruptible power supply according to any one of claims 1 to 3, wherein when an alternating current of the alternating current input end (20) is in a predetermined range, the switch (S) is controlled so that the first output end (N41) and the second output end (N42) of the inversion voltage regulating circuit (40) are electrically connected to the alternating current output end (30), the first switching tube (Q1) and the second switching tube (Q2) are controlled to be on, the third switching tube (Q3) and the sixth switching tube (Q6) are controlled to be on in a positive half cycle of the alternating current, and the fourth switching tube (Q4) and the fifth switching tube (Q5) are controlled to be on in a negative half cycle of the alternating current.
